Europäisches Patentamt

European Patent Office

Office européen des brevets

(19)

(11) Veröffentlichungsnummer : **0 075 920**
**B1**

(12) **EUROPÄISCHE PATENTSCHRIFT**

(45) Veröffentlichungstag der Patentschrift :
23.12.87

(51) Int. Cl.⁴ : **H 05 K   7/20**

(21) Anmeldenummer : **82108941.4**

(22) Anmeldetag : **27.09.82**

(54) Einrichtung zum Kühlen von Baugruppen in elektronischen Anlagen.

(30) Priorität : 29.09.81 DE 8128502 U

(43) Veröffentlichungstag der Anmeldung :
06.04.83 Patentblatt 83/14

(45) Bekanntmachung des Hinweises auf die Patenterteilung : 23.12.87 Patentblatt 87/52

(84) Benannte Vertragsstaaten :
FR GB NL

(56) Entgegenhaltungen :
DE-A- 2 744 664

(73) Patentinhaber : **Siemens Aktiengesellschaft Berlin und München**
**Wittelsbacherplatz 2**
**D-8000 München 2 (DE)**

(72) Erfinder : **Birken, Klaus-Peter**
**Wischhoff 5a**
**D-2057 Wentorf (DE)**

Jouve, 18, rue St-Denis, 75001 Paris, France

## Beschreibung

Die Erfindung bezieht sich auf eine Einrichtung zum Kühlen von Baugruppen in elektronischen Anlagen, gemäß dem Oberbegriff des Anspruches, insbesondere solchen, die modular aufgebaut sind und in denen Baugruppen mit hoher Verlustleistung gekühlt werden müssen.

Zur Kühlung von solchen Baugruppen wurden bisher modulare Lüfterbaugruppen mit mehreren nebeneinander angeordneten Axiallüftern verwendet, siehe zum Beispiel die DE-A-2 744 664. Wegen des relativ konzentrierten Luftstromes derartiger Axiallüfter waren Zonen unterschiedlicher Temperatur bzw. unterschiedlicher Kühlung bei einem solchen Aufbau nicht zu vermeiden. Der Erfindung lag daher die Aufgabe zugrunde, eine Einrichtung zum Kühlen von Baugruppen in elektronischen Anlagen zu schaffen, bei denen der Luftstrom möglichst gleichmäßig sämtliche sogenannte Bausteingassen kühlt. Gemäß der Erfindung wird dies erreicht durch ein Gehäuse mit mindestens einer Lufteintritts- und einer Luftaustrittsöffnung, durch mindestens zwei nebeneinander angeordnete, mit ihren Achsen fluchtende Radiallüfter, deren Luftaustrittsöffnungen an die Luftaustrittsöffnungen des Gehäuses angrenzen, durch trichterförmige Erweiterung der Luftaustrittsöffnungen und durch über diesen angeordnete Luftleitbleche.

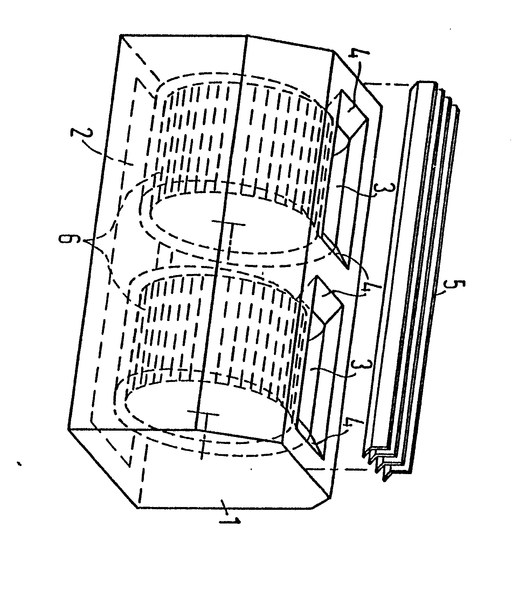

Die Zeichnungs zeigt ein Ausführungsbeispiel der erfindungsgemäßen Einrichtung und läßt insbesondere erkennen, daß in einem Gehäuse 1 einer Lufteintrittsöffnung 2 und zwei Luftaustrittsöffnungen 3 zwei mit ihren Achsen fluchtende Radiallüfter 6 nebeneinander angeordnet sind, wobei deren Luftaustrittsöffnungen an die Luftaustrittsöffnungen 3 des Gehäuses angrenzen. Weiterhin ist ersichtlich, daß die Luftaustrittsöffnungen 3 trichterförmige Erweiterungen 4 aufweisen. Über dem Gehäuse und unmittelbar über den Luftaustrittsöffnungen 3 desselben sind Luftleitbleche 5 angeordnet. In der Zeichnung wurden der besseren Übersicht halber diese Luftleitbleche 5 gegenüber dem Gehäuse 1 nach oben versetzt dargestellt. In Wirklichkeit sitzen diese aber unmittelbar über den Luftaustrittsöffnungen 3 des Gehäuses 1.

Mit einer solchen Einrichtung läßt sich ein Luftstrom mit großer Luftmenge und hoher Luftgeschwindigkeit erzeugen, der durch die Anordnung der Radiallüfter nebeneinander, durch die trichterartigen Erweiterungen 4 der Austrittsöffnungen 3 und durch die Luftleitbleche über den Luftaustrittsöffnungen in Längsrichtung des Gehäuses verbreitert und damit auf eine größere Fläche gedrückt wird. Durch die Anordnung der Luftleitbleche 5 wird aber nicht nur eine gleichmäßige Verteilung der Luftströmung auch in Querrichtung erreicht, sondern außerdem auch noch der turbulente Luftstrom beruhigt. Die erfindungsgemäße Einrichtung schafft dadurch eine gleichmäßige, günstige Kühlluftverteilung auf allen Einbauplätzen einer elektronischen Anlage mit Baugruppen in beiden Richtungen, d. h. in Längs- und in Querrichtung.

## Patentanspruch

Einrichtung zum Kühlen von Baugruppen in elektronischen Anlagen mittels Radiallüftern, dadurch gekennzeichnet, daß in einem unten mit mindestens einer Lufteintrittsöffnung (2) und oben mit mindestens einer eine trichterförmige Erweiterung (4) aufweisenden Luftaustrittsöffnung (3) versehenen Gehäuse (1) mindestens zwei nebeneinander angeordnete mit ihren Achsen fluchtende und parallel zur Gehäuseachse verlaufende Radiallüfter angeordnet sind und daß oberhalb der Luftaustrittsöffnung (3) Luftleitbleche angeordnet sind.

## Claim

Apparatus for cooling modules in electronic equipment by means of radial ventilators, characterised in that in a housing (1), provided below with at least one opening (2) for the entry of air and above with at least one exit (3) for air which has a funnel-shaped widening (4), at least two radial ventilators are positioned next to one another with their axes in alignment and running parallel to the axis of the housing ; and that above the exits (3) for air, air baffle plates are arranged.

## Revendication

Dispositif pour refroidir des modules dans des installations électroniques à l'aide de ventilateurs radiaux, caractérisé par le fait que dans un carter (1) comportant dans le bas au moins une ouverture d'entrée de l'air (2) et en haut une ouverture de sortie de l'air (3) présentant au moins un élargissement (4) en forme d'entonnoir, sont disposés au moins deux ventilateurs radiaux agencés côte à côte avec leurs axes alignés et parallèles à l'axe du carter, et qu'au-dessus de l'ouverture de sortie de l'air (3) sont disposées des tôles de guidage de l'air.